# EUROPÄISCHE PATENTSCHRIFT

(11) **EP 0 512 456 B1**
(45) Veröffentlichungstag und Bekanntmachung des Hinweises auf die Patenterteilung: **18.06.1997**
(21) Anmeldenummer: 92107498.5
(22) Anmeldetag: 04.05.1992
(51) Int. Cl.: C23C 14/34, H01J 37/34

(54) **Verfahren zur Montage bzw. Demontage einer Targetplatte in einem Vakuumprozessraum, Montageanordnung hierfür sowie Targetplatte bzw. Vakuumkammer**
Process for fitting and removal of a target plate in a vacuum processing chamber, fitting therefor, target plate and vacuum chamber
Procédé de montage et démontage d'une plaque cible dans une chambre de traitement sous vide, dispositif de montage, plaque cible et chambre à vide

(30) Priorität: 08.05.1991 CH 1386/91
(43) Veröffentlichungstag der Anmeldung: 11.11.1992
(73) Patentinhaber: BALZERS AKTIENGESELLSCHAFT, 9496 Balzers (LI)
(72) Erfinder: Kerschbaumer, Jörg, A-6800 Feldkirch-Tosters (AT)
(74) Vertreter: Troesch Scheidegger Werner AG

(56) Entgegenhaltungen:
- EP-A- 0 393 344
- EP-A- 0 499 770
- US-A- 4 657 654
- US-A- 5 009 765
- PATENT ABSTRACTS OF JAPAN vol. 12, no. 56 (C-477)(2903) 19. Februar 1988; & JP-A-62 199 769

## Beschreibung

Die vorliegende Erfindung betrifft ein Verfahren zur Montage bzw. Demontage einer zu kühlenden Targetplatte in einem Vakuumprozessraum nach dem Oberbegriff von Anspruch 1, eine Targetmontageanordnung zur Ausführung dieses Verfahrens nach dem Oberbegriff von Anspruch 5 sowie eine Targetplatte nach den Ansprüchen 8 bzw. 10 und eine Vakuumkammer hier mit nach Anspruch 11. Sie betrifft weiter eine Verwendung des genannten Verfahrens bzw. der genannten Anordnung nach Anspruch 12.

Bekanntlich werden bei verschiedenen Vakuumprozessen Targetplatten eingesetzt, welche im Laufe der Prozesse verbraucht werden.

Bei der einen Art reaktiver oder nicht reaktiver Beschichtungsprozesse wird das Target durch eine DC- oder AC-Glimmentladung durch Ionenbeschuss grossflächig zerstäubt und die abgestäubten Targetpartikel, direkt oder mit einem Reaktivgas reagiert, auf Werkstücke abgelegt, um diese zu beschichten. Dabei wird das Target oft - beim sog. Hochratezerstäuben - mit einer Magnetronanordnung betrieben, wodurch die Ionendichte im Targetbereich erhöht wird.

Bei einer anderen Art der genannten Beschichtungsprozesse wird das Target durch Lichtbogen lokal verdampft oder durch Elektronenstrahlbeschuss.

In jedem Fall wird das Target durch den Zerstäubungs- bzw. Verdampfungsprozess thermisch stark belastet, sei dies durch den Ionen-, den Elektronenbeschuss oder den auftreffenden Lichtbogen.

Alle Targetplatten sollten einfach und ohne Demontage grösserer Vakuumkammerteile ersetzbar sein, wobei oft sicherzustellen ist, dass nicht prozessfremde Materialien von Befestigungsorganen gegen den Prozessraum freiliegen, da solche bei ihrer Mitzerstäubung oder -verdampfung heikle Beschichtungsprozesse unzulässig kontaminieren würden.

Für die Abfuhr der Wärme werden Targetplatten bekanntlich z.B. auf einer Kühlplattenanordnung montiert.

Die grösste Wärmeabfuhr liesse sich dadurch erreichen, dass die Targetplattenrückseite direkt mit einem Kühlmedium, flüssig oder gasförmig, in Kontakt gebracht wird. Diese Kühlart ist aus vakuumtechnischen Gründen meist nicht erwünscht.

Deshalb ist es beispielsweise aus der EP-A-0 334 347 oder dem Artikel "Cathode cooling apparatus for a planar magnetron sputtering system", M.R. Lake and G.L. Harding, aus J.Vac.Sci.Technol. A 2(3), July-Sept. 1984, American Vacuum Society, S. 1391 f., oder aus der SU-Patentschrift Nr. 823 459, der EP-A-0 393 344, bekannt, ein Leitungssystem für das Kühlmedium von der Auflagefläche an der Targetplatte durch eine dünne, membranartige bzw. folienartige, wärmeleitende Wandung zu trennen, womit einerseits die vakuumtechnischen Dichtungsprobleme, gegenüber einer direkten Kühlung, entfallen, anderseits, durch den Druck des Kühlmediums auf die membranartige Zwischenwand und auf die Targetplattenrückseite, ein sehr guter Wärmedurchgang von Targetplatte auf Kühlmedium gewährleistet werden kann. Dabei werden die Druckkräfte des Mediums von der Targetplatte aufgenommen. Ist die mechanische Belastbarkeit der Targetplatte, sei dies aufgrund ihrer Dimensionierung und/oder der Eigenschaften des Targetmaterials, zu gering, so ist es üblich, die Targetplatte aus einer Platte aus Targetmaterial und einer Targetrückplatte auszubilden, sie z.B. zusammenzubonden. Die Rückplatte nimmt dann einen Grossteil der mechanischen Beanspruchungen der Targetplatte auf.

Bei kleinen Targetplatten reicht im allgemeinen eine Befestigung an deren Rand, beispielsweise mittels eines Klemmrahmens; grössere Targetplatten werden üblicherweise zusätzlich in ihrem Mittenbereich befestigt.

Die Targetplattenbefestigung erfolgt entweder von der Prozessraumseite her, d.h. von vorne, oder von der Kühlplatte her, von hinten. Eine Targetplattenbefestigung von vorne (CH-A-664 303) hat den Vorteil, dass eine leichte Demontage und Montage der Platte möglich ist, ohne dass die Kühlplatte demontiert werden muss. Nachteilig dabei ist, dass ein vom Targetmaterial abweichendes Material der Befestigungsorgane, wie von Schrauben, gegen den Prozessraum freiliegt, dem dadurch Rechnung zu tragen ist, dass die Targetplatte nicht ganzflächig zerstäubt werden kann. Dies hat wiederum Auswirkungen auf die Schichtdickenverteilung der durch Zerstäubung hergestellten Schichten bzw. auf die Ausnutzung des oft teuren Targetmaterials.

Eine Mitzerstäubung solcher von vorne, d.h. vom Prozessraum her vorgesehener Befestigungsorgane kann nie vollständig ausgeschlossen werden, weshalb solche Befestigungen bei heiklen, höchsten Anforderungen genügenden Beschichtungsprozessen vermieden werden.

Eine Targetplattenbefestigung mit Verschraubung von hinten (CH-A-669 242) hat zwar den Vorteil, dass das Target an der gesamten Vorderseite zerstäubt werden kann, jedoch den Nachteil, dass beim Targetwechsel die Kühlplatte, von welcher her die Befestigungsorgane vorgesehen werden, demontiert werden muss.

Aus der US-A-5 009 765 ist es bekannt, eine Targetplatte auf einen Trägerzylinder zu schweissen oder zu bonden.

Der Trägerzylinder weist radial auskragende Laschen an einem Kragen auf, mit deren Hilfe er in Einnehmungen vakuumkammerseitig festgespannt wird. Der Zylinder mit daran befestigter Targetplatte definiert einen Zylinderinnenraum wesentlich höher als die Targetplattendicke, der dazu dient, ein relativ grosses Kühlflüssigkeitsvolumen aufzunehmen.

An dieser Anordnung ist es nachteilig, dass mit der eigentlichen Targetplatte ein relativ komplizierter Teil, der Trägerzylinder, auszuwechseln ist, der im allgemeinen aus Fertigungs- und/oder Kostengründen nicht aus dem gleichen Material wie die Targetplatte gefertigt ist, womit aber dann prozessfremdes Material des Trägerzylinders mitzerstäubt wird.

Die eigentliche Befestigung der Targetplatte, die Schweissnaht, ist hohen thermischen und mechanischen (Kühlmedium/Vakuum) Beanspruchungen ausgesetzt, was unter Berücksichtigung einzusetzender Materialpaarungen Targetplatte/Trägerzylinder zu beurteilen ist.

Aus der US-A-4 657 654 ist es bekannt, eine Targetplatte in einen Kühlring dadurch einzulassen, dass lateral von der Platte vorspringende Bolzen in kühlringseitige Bajonettnuten eingehakt werden. Durch thermische Wärmeausdehnung der Platte gegen den Kühlring wird sowohl eine mechanische Plattenverspannung wie auch Wärmeübergang erreicht.

Aus der EP-0 393 344 ist ein Verfahren bzw. eine Montageanordnung eingangs genannter Art bekannt. Dabei ist die Targetplatte so dimensioniert, dass flächige Auskragungen an der Platte mühelos unter flächige Auskragungen am Träger eingeschoben werden können.

Die vorliegende Erfindung setzt sich zum Ziel, ausgehend von einem Verfahren bzw. einer Anordnung letztgenannter Art, sicherzustellen, dass nur tolerable mechanische Spannungen an der Platte entstehen, wenn sie sich thermisch bedingt ausdehnt, und dass die Targetplatte ohne zusätzliche, aufwendige Halte- und Stützteile vom Prozessraum her gewechselt werden kann, womit ein schnelles Auswechseln im wesentlichen nur gerade des Verbrauchsteils, nämlich der Targetplatte, ermöglicht wird.

Dies wird bei Vorgehen nach dem kennzeichnenden Teil von Anspruch 1 erreicht bzw. bei einer Montageanordnung, die sich nach dem kennzeichnenden Teil von Anspruch 5 auszeichnet.

Dadurch wird erreicht, dass
- die Platte selbst gewechselt werden kann, und zwar von der Prozessseite her,
- ausser Partien der Kammerwand, die ohnehin gegen den Prozessraum freiliegt, keine zusätzlichen Befestigungsorgane bzw. Spannorgane vorzusehen sind,
- die Doppelfunktion des Kühlmediums zum Kühlen der Targetplatte und zum Spannen bzw. Lösen des Verschlusses beibehalten wird und
- die Targetplatte in klar definierter Position montiert wird, definiert durch die Bajonettverschlussanschläge,
- nur tolerable mechanische Spannungen im Target entstehen, wenn es sich thermisch bedingt ausdehnt.

Durch Vorgehen nach Anspruch 2 wird eine besonders einfache Handhabung möglich.

Es wird ermöglicht, je nach Ausdehnung, Dicke und Material der, wie erwähnt, hoch belasteten Targetplatte, sie in ihrem Zentralbereich und/oder in ihrem Peripheriebereich gegen den Druck des Kühlmediums widerzulagern bei Vorgehen nach dem Wortlaut von Anspruch 3.

Wird z.B. in bevorzugter Art und weise ein Drehbajonettverschluss für die Platte vorgesehen, so wird die ganze Platte in ihrer Radialausdehnung nicht formschlüssig eingespannt, sondern nur in Richtung ihrer Normalen.

Aus Patent Abstracts of Japan, vol. 12, no. 56 (C-477) (2903), 19. Februar 1988, und JP, A, 62 199 769 (Hitachi), 3. September 1987, ist es bekannt, im Rahmen eines Bedampfungsprozesses Werkstücke mit einem Träger in einer Vorkammer aufzunehmen, Träger und Werkstück durch ein Schleusenventil in den Bedampfungsraum einzubringen, dort den Träger linear in eine seitliche Halterungsführung einzuschieben und diese durch Wirkung eines Kühlstempels zu spannen.

Die Wahl des Trägermaterials und des Materials dafür vorgesehener Befestigungsorgane ist bei einem Bedampfungsprozess - bei dem, anders als eine Targetplatte, nicht dieser Träger verdampft wird - unkritisch. Obwohl als "bayonet" bezeichnet, handelt es sich bei den seitlichen Halterungsführungen, ähnlich Schubladenführungen, nicht um einen eigentlichen Bajonettverschluss, bei dem eine Verschliessung erst durch Relativbewegung der zu verschliessenden Teile in zwei separaten Richtungen erfolgt, sei dies linear, entsprechend x-, y-Richtungen, oder wie bei einem Drehbajonett durch axiales Verschieben und Verdrehen um diese Achse.

Im weiteren ist die thermische Belastung eines vakuumbedampften Trägers wesentlich geringer als die eines zerstäubten oder verdampften Targets, weil nur bei letzterem die aufgebrachte Energie zur Zerstäubung oder Verdampfung führen muss. Damit ist das Festspannen eines solchen Trägers wesentlich unproblematischer als dasjenige einer Targetplatte gemäss vorliegender Erfindung.

Weitere Vorteile werden aus der anschliessenden beispielsweisen Beschreibung der Erfindung ersichtlich.

Sie wird anschliessend beispielsweise anhand von Figuren erläutert.

Es zeigen:
- Fig. 1: eine schematische Querschnittsdarstellung einer erfindungsgemässen Montageanordnung für eine Targetplatte, in entspanntem Zustand,
- Fig. 2: die Anordnung gemäss Fig. 1 in gespanntem Zustand,
- Fig. 3: eine Darstellung analog zu Fig. 1, nur mit Zentrumsverschluss,
- Fig. 4: eine Darstellung analog zu Fig. 1, nur mit Peripherieverschluss,
- Fig. 5: die Aufsicht auf den vakuumkammerseitigen Teil eines erfindungsgemässen Bajonettverschlusses,
- Fig. 6: einen verbrauchsplattenseitigen Bajonettverschlussteil in Aufsicht,
- Fig. 7: eine montierte Targetplatte mit Bajonettverschluss gemäss den Fig. 5 und 6, als Peripherieverschluss ausgebildet.

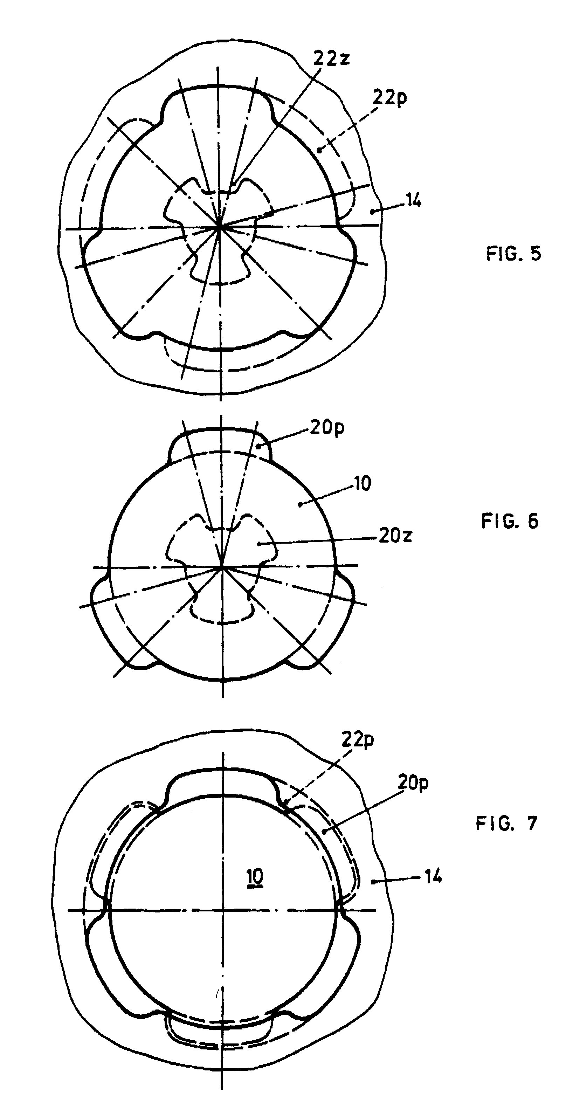

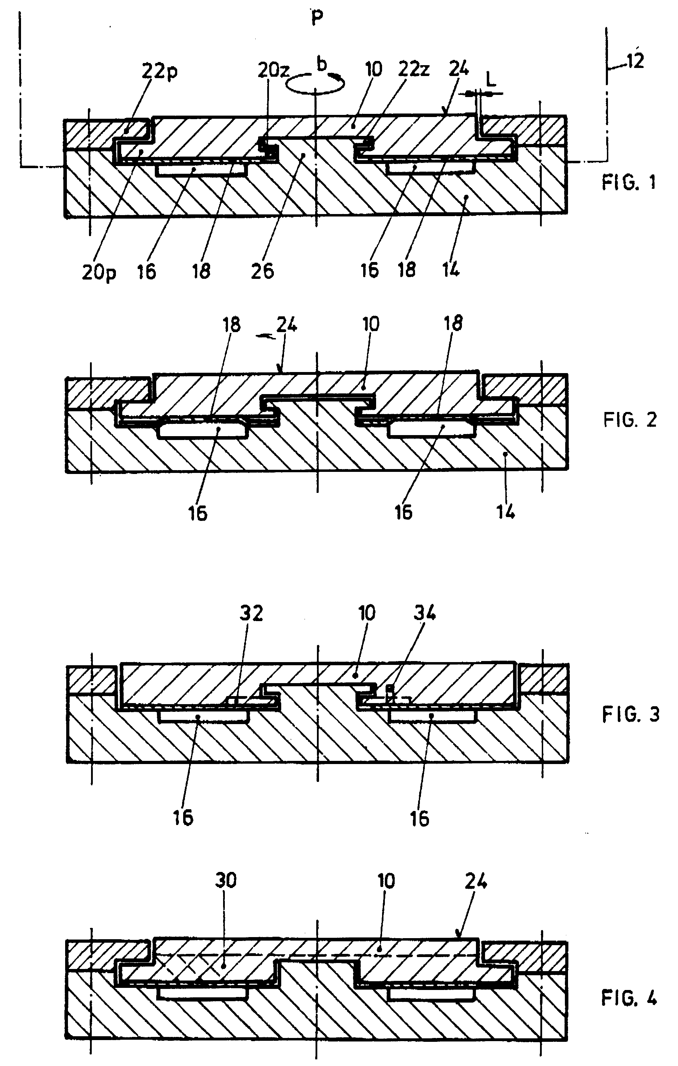

In Fig. 1 ist, schematisch, eine erfindungsgemäss montierte Targetplatte 10 dargestellt. Eine strichpunktiert angedeutete Vakuumkammer 12 umfasst eine Kühlplatte 14 mit Kanälen 16 für ein Kühlmedium, flüssig oder gasförmig, üblicherweise für Wasser. Die Kanäle 16 in der Kühlplatte 14 sind gegen den Prozessraum P hin mit gut wärmedurchleitenden Membranen 18, vorzugsweise Metallfolien, dichtend verschlossen.

Die Targetplatte 10 sowie die Kühlplatte 14 weisen je im Zentrum und an der Peripherie Bajonettverschlussteile auf, so die Targetplatte 10 radial aus- bzw. einspringende Partien 20p und 20z und die Kühlplatte 14 entsprechende Bajonettverschlusspartien 22p bzw. 22z. Dabei bilden die Teile 22p Teil der Kammerwand der Vakuumkammer 12. Die kühlplatten- und targetplattenseitigen Bajonettverschlussteile 20, 22 gemäss Fig. 1 bilden zwei koaxial angeordnete Bajonettverschlüsse, entsprechend den Indices p und z, welche, wie mit dem Pfeil b dargestellt, durch Verschwenken der Targetplatte im wesentlichen parallel zu der dem Prozessraum P zugewandten Targetoberfläche 24 geschlossen bzw. geöffnet werden. Es wird auf das radiale Spiel zwischen Targetplatte 10 und kammerseitiger Trägeranordnung hingewiesen, das eine thermische Radialausdehnung der Platte 10 im wesentlichen spannungsfrei zulässt.

Eine Ausbildung der Bajonettverschlussteile ist in den Fig. 5 bis 7 in Aufsicht dargestellt, wobei dort primär die Ausbildung des Peripherieverschlusses dargestellt ist, und, in den Fig. 5 und 6 gestrichelt, die zusätzliche Ausbildung des Zentralverschlusses, entsprechend den Indices z.

Bei der Darstellung von Fig. 1 ist das Kühlmedium in den Kanälen 16 noch nicht unter Druck gesetzt. In diesem Zustand besteht zwischen Targetplatte und Kühlplatte axiales und radiales Spiel, so dass die Targetplatte 10 nach dem Aufsetzen auf die Kühlplatte leicht durch Drehen in das Bajonett geschoben werden kann. Dabei wird das Target trotz des radialen Spiels L im Peripheriebereich durch den zentralen Bajonettzapfen an der Kühlplatte 14, bei 26 eingetragen, gegenüber der Kühlplatte 14 zentriert.

In Fig. 2 ist das Kühlmedium in den Kanälen 16 der Anordnung gemäss Fig. 1 unter Druck gesetzt, wodurch sich die Membrane 18, wie erwähnt vorzugsweise durch Metallfolien gebildet, gegen die Targetplatte 10 legt und diese axial im Rahmen des vorgesehenen axialen Spiels hochhebt. Dadurch wird der Bajonettverschluss verspannt und gleichzeitig ein guter Wärmeübergang von Targetplatte 10 über die Metallfolie 18 auf das Medium in den Kanälen 16 sichergestellt. Trotz des axialen Verspannens des Bajonettverschlusses bleibt das radiale Spiel L der Targetplatte 10 bezüglich der Kühlplatte 14 an der Vakuumkammer 12 bestehen, so dass sich die Targetplatte 10 thermisch frei radial ausdehnen kann. Bei axialer Ausdehnung arbeitet sie gegen den Druck des Mediums in den Kanälen 16. Dadurch werden thermisch bedingte Spannungen im Target reduziert und mithin Verformungen der Targetoberfläche 24.

Damit wird grundsätzlich erreicht, dass Targetplatten 10 besser ausgenützt werden können, teilweise, wie in den Fig. 1 und 2 dargestellt, Targets ohne versteifende Platten einsetzbar sind und damit billiger werden und grössere Targetplatten realisiert werden können.

Wie noch gezeigt werden wird, können anstelle von zentralen und peripheren Bajonettverschlüssen auch nur zentrale oder nur periphere eingesetzt werden, was sich nach den Dimensionen, insbesondere dem Verhältnis Targetausdehnung zu Targetdicke, und dem Targetmaterial - spröd oder eher duktil - und der Targetbetriebstemperatur entscheiden lässt.

In Fig. 3 ist eine Targetplatte 10 analog zu Fig. 1 dargestellt, bei entspanntem Medium in den Kanälen 16, wobei die Bajonettverschlussanordnung lediglich einen Zentralbajonettverschluss umfasst.

In Fig. 4 ist, analog, die entspannte Verschlussanordnung dargestellt mit nur peripherem Bajonettverschluss.

Wie als Beispiel an der Anordnung gemäss Fig. 4 dargestellt, kann die eigentliche Targetplatte 10 mit der zu zerstäubenden Oberfläche 24 je nach Targetmaterial, Dimension und der Targetbetriebstemperatur auf eine Versteifungsplatte 30 montiert sein, beispielsweise gebondet sein, wobei dann, im Sinne der vorliegenden Erfindung, Platte 10 und Versteifungsplatte 30 gemeinsam die Targetplatte bilden.

Im weiteren können, wie gestrichelt in Fig. 3 eingetragen, die den Bajonettverschlussteil oder die Bajonettverschlussteile an der Targetplatte 10 bildenden Partien durch separate Bauteile, Bajonettverschlussrahmen 32, gebildet sein, welche nach Verbrauch des Targets 10 wieder eingesetzt werden für ein nächstes Target und hierzu beispielsweise, wie bei 34 dargestellt, mit der Targetplatte verschraubt sind.

Es hat sich gezeigt, dass die vorgeschlagene Technik sich insbesondere beim Einsatz von Aluminium- oder Aluminiumlegierungstargets ausgezeichnet eignet.

## Patentansprüche

1. Verfahren zur Montage bzw. Demontage einer zu kühlenden Targetplatte in einem Vakuumprozessraum, bei welchem die Platte (10) mittels flächiger Auskragungen (20p, 20z) unter flächige Auskragungen (22p, 22z) an einem Träger (14) lose und im wesentlichen parallel zur Plattenebene eingeschoben wird, darnach die sich hintergreifenden Auskragungen durch Druckbeaufschlagung der Platte mittels eines Kühlmediums verspannt werden und umgekehrt für die Demontage, dadurch gekennzeichnet, dass die flächigen Auskragungen (20p, 20z; 22p, 22z) an Platte (10) und Träger (14) jeweils Aussparungen zwischen sich festlegen, die Auskragungen (20p, 20z) an der Platte (10) quer zur Plattenebene in die Aussparungen trägerseitig lose eingeführt werden und bajonettartig lose unter die trägerseitigen Auskragungen (22p, 22z) geschoben werden, dabei ein thermisch bedingter Verzug der Platte (10) durch Spiel der plattenseitigen Ausformungen (20p, 20z) bezüglich des Trägers (14) und der trägerseitigen Ausformungen (22p, 22z) bezüglich der Platte (10) vermieden wird.

2. Verfahren nach Anspruch 1, dadurch gekennzeichnet, dass man durch eine Relativdrehung der Platte (10) die Auskragungen (20p, 20z) an der Platte (10) unter die trägerseitigen (22p, 22z) schiebt.

3. Verfahren nach Anspruch 1 oder 2, dadurch gekennzeichnet, dass man Auskragungen an der Platte (10) sowie trägerseitig (14) im Zentrumsbereich und/oder im Peripheriebereich bezüglich der Platte (10) vorsieht.

4. Verfahren nach einem der Ansprüche 1 bis 3, dadurch gekennzeichnet, dass man das Medium über eine Trennmembran, wie z.B. eine Metallfolie, auf die Platte (10) zur Wirkung bringt.

5. Targetmontageanordnung zur Ausführung des Verfahrens nach einem der Ansprüche 1 bis 4 mit flächigen Auskragungen (20p, 20z) an einer Targetplatte (10) sowie flächigen Auskragungen (22p, 22z) an einem Targetträger (14), wobei die plattenseitigen Auskragungen (20p, 20z) unter die trägerseitigen (22p, 22z) im wesentlichen parallel zur Plattenebene lose einschiebbar sind, und mit einer targetseitigen Kanalanordnung (16) für ein Kühlmedium mit unter Druck des Mediums gegen die lose eingeschobene Platte (10) spannbarer, membranartiger Trennwand (18), dadurch gekennzeichnet, dass die flächigen Auskragungen (20p, 20z; 22p, 22z), träger(14)- und platten(10)seitig, zwischen sich Aussparungen aufweisen, derart, dass die plattenseitigen Auskragungen (20p, 20z) lose in die trägerseitigen Aussparungen quer zur Plattenebene einführbar sind und darnach, durch Relatiwerschiebung im wesentlichen parallel zur Plattenebene, die Auskragungen (20p, 20z; 22p, 22z) lose bajonettartig hinterhakbar sind, und dass weiter die plattenseitigen Auskragungen (20p, 20z) bezüglich des Trägers (14) und die trägerseitigen Auskragungen (22p, 22z) bezüglich der Targetplatte (10) Spiel aufweisen zur Aufnahme thermischer Plattenausdehnung.

6. Anordnung nach Anspruch 5, dadurch gekennzeichnet, dass an der Platte Auskragungen (20p, 20z) in deren Mittenbereich angeordnet sind und/oder an deren Peripheriebereich.

7. Anordnung nach einem der Ansprüche 5 oder 6, dadurch gekennzeichnet, dass die Platte (10) radial zu kammerseitigen Teilen (14) Spiel (L) aufweist.

8. Targetplatte für eine Montageanordnung nach einem der Ansprüche 5 bis 7, dadurch gekennzeichnet, dass sie eine aus zu zerstäubendem Material bestehende Platte aufweist und eine Stabilisierungsplatte (30), worauf sie montiert ist, wie daran festgebondet ist, wobei die Auskragungen (20p, 20z) an der Stabilisierungsplatte vorgesehen sind.

9. Targetplatte nach Anspruch 8, dadurch gekennzeichnet, dass die Auskragungen (20p, 20z) daran lösbar befestigt sind.

10. Targetplatte für eine Montageanordnung nach einem der Ansprüche 5 bis 7, dadurch gekennzeichnet, dass die Auskragungen (20p, 20z) daran lösbar befestigt sind.

11. Vakuumkammer mit einer Montageanordnung nach einem der Ansprüche 5 bis 7.

12. Verwendung des Verfahrens nach einem der Ansprüche 1 bis 4 oder der Montageanordnung nach einem der Ansprüche 5 bis 7 an einer Targetplatte in einem Abstäubungs- oder Verdampfungsprozess zur Beschichtung eines Werkstückes, wie in einem Ionenstrahlzerstäubungsprozess, einem Plasmazerstäubungsprozess, einem Elektronenstrahlverdampfungsprozess oder einem Lichtbogenverdampfungsprozess, alle reaktiv oder nicht reaktiv.

## Claims

1. Process for assembly or disassembly of a target plate to be cooled in a vacuum process chamber, where the plate (10) is inserted loosely and essentially parallel to the plate plane by means of tabular projections (20p, 20z) under tabular projections (22p, 22z) on a carrier (14), then the projections engaging behind each other are tensioned by pressure impact on the plate by means of a cooling medium and vice versa for disassembly, characterized in that the tabular projections (20p, 20z; 22p, 22z) on the plate (10) and carrier (14) define between them recesses, the projections (20p, 20z) on the plate (10) are inserted loosely transverse to the plate plane in the recesses on the carrier and pushed loosely in a bayonet-like fixing below the projections on the carrier (22p, 22z), where a thermally induced withdrawal of the plate (10) is avoided by play in the recesses on the plate (20p, 20z) in relation to the carrier (14) and the recesses on the carrier (22p, 22z) in relation to the plate (10).

2. Process according to claim 1, characterized in that by a relative twist of the plate (10), the projections (20p, 20z) on the plate (10) are pushed under those on the carrier (22p, 22z).

3. Process according to claim 1 or 2, characterized in that projections are provided on the plate (10) and on the carrier (14) in the central area and/or in the peripheral area with regard to the plate (10).

4. Process according to any of claims 1 to 3, characterized in that the medium is brought to act on the plate (10) by means of a separating membrane eg. a metal foil.

5. Target assembly arrangement for performance of the process according to any of claims 1 to 4, with tabular projections (20p, 20z) on a target plate (10) and tabular projections (22p, 22z) on a target carrier (14), where the projections (20p, 20z) on the plate can be pushed loosely under those (22p, 22z) on the carrier essentially parallel to the plate plane, and with a channel arrangement (16) on the target side for a coolant medium with a membrane-like separating wall (18) tensionable under pressure of the medium against the loosely inserted plate (10), characterized in that the tabular projections (20p, 20z; 22p, 22z) on the carrier (14) and plate (10) have between them recesses such that the projections on the plate (20p, 20z) can be introduced loosely into the recesses on the carrier transverse to the plate plane and then by relative displacement essentially parallel to the plate plane, the projections (20p, 20z; 22p, 22z) can be engaged behind each other loosely as a bayonet-like fixing and that also the projections on the plate (20p, 20z) have some play in relation to the carrier (14) and the projections (22p, 22z) on the carrier in relation to the target plate (10) to absorb thermal plate expansion.

6. Arrangement according to claim 5, characterized in that the projections on the plate (20p, 20z) are arranged in its centre area and/or in its peripheral area.

7. Arrangement according to any of claims 5 or 6, characterized in that the plate (10) has play (L) radial to the chamber parts (14).

8. Target plate for an assembly arrangement according to any of claims 5 to 7, characterized in that it has a plate consisting of a material to be sputtered and a stabilizing plate (30) on which it is mounted and firmly attached, where the projections (20p, 20z) are provided on the stabilizing plate.

9. Target plate according to claim 8, characterized in that the projections (20p, 20z) are removably attached to this.

10. Target plate for an assembly arrangement according to any of claims 5 to 7, characterized in that the projections (20p, 20z) are removably attached to this.

11. Vacuum chamber with an assembly arrangement according to any of claims 5 to 7.

12. Use of the process according to any of claims 1 to 4 or the assembly arrangement according to any of claims 5 to 7 on a target plate in a sputtering or vaporization process for coating a workpiece, such as in an ion beam sputtering process, a plasma sputtering process, an electron beam vaporization process or an arc vaporization process, all reactive or non-reactive.

## Revendications

1. Procédé pour le montage ou le démontage d'une plaque cible à refroidir, dans un espace de traitement sous vide, selon lequel la plaque (10) est glissée avec du jeu et globalement parallèlement à son plan, à l'aide de saillies planes (20p, 20z), sous des saillies planes (22p, 22z) prévues sur un support (14), après quoi les saillies qui viennent en prise sont serrées grâce à la mise sous pression de la plaque à l'aide d'un agent réfrigérant, et inversement pour le démontage, caractérisé en ce que les saillies planes (20p, 20z ; 22p, 22z) de la plaque (10) et du support (14) définissent entre elles des cavités et les saillies (20p, 20z) de la plaque (10) sont introduites transversalement par rapport au plan de la plaque et avec du jeu dans les cavités, côté support, et sont glissées à la manière d'une baïonnette, avec du jeu, sous les saillies prévues côté support (22p, 22z), une déformation thermique de la plaque (10) étant évitée grâce au jeu des protubérances -prévues côté plaque (20p, 20z) par rapport au support (14) et des protubérances prévues côté support (22p, 22z) par rapport à la plaque (10).

2. Procédé selon la revendication 1, caractérisé en ce que grâce à une rotation relative de la plaque (10), on glisse les saillies (20p, 20z) de la plaque (10) sous les saillies prévues côté support (22p, 22z).

3. Procédé selon la revendication 1 ou 2, caractérisé en ce qu'on prévoit des saillies sur la plaque (10) et côté support (14) dans la zone centrale et/ou dans la zone périphérique par rapport à la plaque (10).

4. Procédé selon l'une des revendications 1 à 3, caractérisé en ce qu'on fait agir l'agent sur la plaque (10) par l'intermédiaire d'une membrane de séparation comme par exemple une feuille de métal.

5. Dispositif de montage de cible pour la mise en oeuvre du procédé selon l'une des revendications 1 à 4, comportant des saillies planes (20p, 20z) sur une plaque cible (10) et des saillies planes (22p, 22z) sur un support de cible (14), les saillies prévues côté plaque (20p, 20z) étant aptes à glisser avec du jeu sous les saillies prévues côté support (22p, 22z), globalement parallèlement au plan de la plaque, et comportant, côté cible, un dispositif de conduits (16) pour un agent réfrigérant, pourvu d'une cloison en forme de membrane (18) apte à être tendue, sous la pression de l'agent, contre la plaque (10) introduite avec du jeu, caractérisé en ce que les saillies planes (20p, 20z ; 22p, 22z) prévues côté support (14) et côté plaque (10) présentent entre elles des cavités, de telle sorte que les saillies prévues côté plaque (20p, 20z) sont aptes à être introduites avec du jeu, transversalement par rapport au plan de la plaque, dans les cavités situées côté support, puis grâce à un déplacement relatif globalement parallèle au plan de la plaque, les saillies (20p, 20z ; 22p, 22z) sont aptes à s'enclencher par l'arrière, avec du jeu, à la manière d'une baïonnette, et en ce que les saillies prévues côté plaque (20p, 20z) et les saillies prévues côté support (22p, 22z) présentent par rapport au support (14) et à la plaque cible (10), respectivement, un jeu destiné à compenser une dilatation thermique de la plaque.

6. Dispositif selon la revendication 5, caractérisé en ce que sur la plaque, les saillies (20p, 20z) sont disposées dans la zone centrale et/ou sur la zone périphérique.

7. Dispositif selon la revendication 5 ou 6, caractérisé en ce que la plaque (10) présente, radialement par rapport à des éléments situés côté chambre (14), un jeu (L).

8. Plaque cible pour un dispositif de montage selon l'une des revendications 5 à 7, caractérisée en ce qu'elle comporte une plaque formée d'un matériau à pulvériser, et une plaque de stabilisation (30) sur laquelle elle est montée, par exemple par bonding, les saillies (20p, 20z) étant prévues sur la plaque de stabilisation.

9. Plaque cible selon la revendication 8, caractérisée en ce que les saillies (20p, 20z) y sont fixées de façon amovible.

10. Plaque cible pour un dispositif de montage selon l'une des revendications 5 à 7, caractérisée en ce que les saillies (20p ,20z) y sont fixées de façon amovible.

11. Chambre à vide pourvue d'un dispositif de montage selon l'une des revendications 5 à 7.

12. Utilisation du procédé selon l'une des revendications 1 à 4 ou du dispositif de montage selon l'une des revendications 5 à 7 sur une plaque cible lors d'une opération de pulvérisation ou d'évaporation en vue de revêtir une pièce, par exemple lors d'une opération de pulvérisation par faisceau ionique ou par plasma, ou d'une opération d'évaporation par faisceau électronique ou par arc électrique, réactives ou non réactives.
